# FASCICULE DE BREVET EUROPEEN

(11) **EP 1 060 562 B1**
(45) Date de publication et mention de la délivrance du brevet: **09.02.2005**
(21) Numéro de dépôt: 99961134.6
(22) Date de dépôt: 21.12.1999
(51) Int. Cl.: H03H 9/02, H03H 3/08, H03H 9/10

(54) **DISPOSITIF A ONDES ACOUSTIQUES GUIDEES DANS UNE FINE COUCHE PIEZO-ELECTRIQUE COLLEE SUR UN SUBSTRAT PORTEUR ET PROCEDE DE FABRICATION**
ANORDNUNG MIT AKUSTISCHEN WELLEN GELEITET IN EINER PIEZOELEKTRISCHEN DÜNNSCHICHT, GEKLEBT AUF EINEM TRÄGERSUBSTRAT UND VERFAHREN ZUR HERSTELLUNG
DEVICE WITH ACOUSTIC WAVES GUIDED IN A FINE PIEZOELECTRIC MATERIAL FILM BONDED WITH A MOLECULAR BONDING ON A BEARING SUBSTRATE AND METHOD FOR MAKING SAME

(30) Priorité: 30.12.1998 FR 9816661
(43) Date de publication de la demande: 20.12.2000
(73) Titulaire: Thales, 75008 Paris (FR)
(72) Inventeur: WRIGHT, Peter, Thomson-CSF Propriété Intell., F-94117 Arcueil Cedex (FR)
(86) Numéro de dépôt international: PCT/FR1999/003239
(87) Numéro de publication internationale: WO 2000/041299

(56) Documents cités:
- EP-A- 0 350 993
- EP-A- 0 602 666
- EP-A- 0 616 426
- EP-A- 0 647 022
- W.R. SMITH: "COUPLING EFFICIENCY ESTIMATES FOR SWA EXCITATION WITH PIEZOELECTRIC FILM OVERLAYS" JOURNAL OF APPLIED PHYSICS., vol. 42, no. 7, juin 1971 (1971-06), pages 3016-3018, XP002116118 AMERICAN INSTITUTE OF PHYSICS. NEW YORK., US ISSN: 0021-8979
- C.T. CHUANG ET AL: "COUPLING OF INTERDIGITAL TRANSDUCER TO PLATE MODES IN A SLOTTED ACOUSTICALLY THIN MEMBRANE" IEEE ELECTRON DEVICE LETTERS., vol. 4, no. 2, février 1983 (1983-02), pages 35-38, XP002116119 IEEE INC. NEW YORK., US ISSN: 0741-3106

## Description

Le domaine de l'invention est celui des dispositifs à ondes acoustiques de surface, notamment utilisés comme filtres dans la téléphonie mobile.

Pour réaliser des fonctions de type filtres et résonateurs avec des dispositifs à ondes acoustiques de surface, il est important de réaliser des fonctions de transduction et des fonctions de réflexion les plus efficaces possibles.

Typiquement, un résonateur à ondes acoustiques de surface est constitué d'un transducteur à ondes acoustiques de surface entre deux réseaux d'électrodes réfléchissants placés de manière appropriée afin de piéger l'énergie acoustique et ainsi créer une cavité résonante pour laquelle on recherche un faible taux de perte de réflexion. Ceci peut être obtenu avec beaucoup d'électrodes, en effet, le coefficient de réflexion effectif d'une seule électrode n'est que de quelques pour-cent. Ainsi ce sont quelques cent électrodes, voire plus, espacés uniformément à raison de deux électrodes par longueur d'onde qui constituent ces réseaux. La faiblesse de réflexion d'une électrode a essentiellement deux raisons : l'électrode étant à la surface, ne réagit pas fortement avec l'onde acoustique dont l'énergie diffuse dans le substrat (augmenter de manière significative cette interaction requerrait des électrodes d'une finesse dans la pratique irréalisable), de plus si le coefficient de réflexion d'une seule électrode est très élevé, une énergie substantielle est dispersée sous forme d'ondes de volume et par suite, perdue pour l'ensemble du résonateur.

Pour augmenter l'efficacité des réseaux et donc les performances des résonateurs, il est particulièrement avantageux d'utiliser un guide d'énergie acoustique c'est-à-dire utiliser une fine couche de matériau piézo-électrique dans laquelle les ondes acoustiques peuvent être confinées.

Un tel dispositif est connu p.ex. du document EP0616426A1.

Les transducteurs à ondes acoustiques de surface exploitent de plus en plus les réflexions à l'intérieur pour effectuer une émission acoustique unidirectionnelle. Donc. ce type de transducteur bénéficie de la même façon d'une augmentation d'efficacité de réflexion. En plus, si l'énergie acoustique est guidée dans une fine couche de matériau piézo-électrique le coefficient de couplage piézo-électrique est plus efficace.

C'est pourquoi l'invention propose un dispositif à ondes acoustiques de surface, guidées dans une fine couche de matériau piézo-électrique, collée sur un substrat porteur, de manière à assurer le confinement des ondes acoustiques dans le matériau piézo-électrique.

Plus précisément, l'invention a pour objet un dispositif à ondes acoustiques de surface comme defini dans la revendication 1.

Le matériau porteur peut être de type verre, saphir, silicium ou bien encore arséniure de gallium. Le matériau piézo-électrique peut être de type quartz, niobate de lithium ou tantalate de lithium, la colle moléculaire peut être de type silice. Selon une variante de l'invention, le dispositif à ondes acoustiques de surface peut comprendre une couche métallique entre la couche de colle moléculaire et la couche de matériau piézo-électrique.

L'invention a encore pour objet un premier procédé de fabrication d'un dispositif à ondes acoustiques comprenant une fine couche de matériau piézo-électrique, une couche de colle moléculaire et un substrat porteur.

Plus précisément, ce procédé qui est defini dans la revendication 14 comporte par ailleurs les étapes suivantes :
- le dépôt d'une couche de colle moléculaire sur une première face d'un substrat de matériau piézo-électrique,
- l'assemblage d'un substrat porteur et de l'ensemble couche de colle moléculaire/substrat de matériau piézo-électrique sous atmosphère humide de manière à réaliser une opération de collage hydrophilique,
- la réduction de l'épaisseur du substrat piézo-électrique par un procédé de type mécanique, chimique, ionique, de manière à définir la couche mince de matériau piézo-électrique.

Avantageusement le procédé peut comprendre les étapes suivantes :
- l'implantation d'ions dans le substrat de matériau piézo-électrique à une profondeur d par rapport à une première face d'un substrat de matériau piézo-électrique ;
- le chauffage rapide de l'assemblage couche de colle moléculaire/substrat de matériau piézo-électrique de manière à craquer le substrat de matériau piézo-électrique au niveau de la profondeur d'implantation ionique et définir la couche mince de matériau piézo-électrique.
- le polissage de la couche mince de matériau piézo-électrique.

L'invention sera mieux comprise et d'autres avantages apparaîtront à la lecture de la description qui va suivre, donnée à titre non limitatif et grâce aux figures annexées parmi lesquelles :
- la figure 1 illustre un premier exemple de dispositif à ondes de surface selon l'invention comprenant un transducteur compris entre deux réseaux réflecteurs ;
- les figures 2a-2e illustrent les étapes de l'un des procédés de fabrication permettant d'obtenir le dispositif à ondes acoustiques, de l'invention ;
- la figure 3 illustre une variante de l'invention dans laquelle le dispositif à ondes de surface comprend une couche supplémentaire métallique de confinement des ondes ;
- les figures 4a-4c illustrent des configurations de transducteurs sans couche conductrice (4a) et avec couche conductrice (4b et 4c) ;
- les figures 5a à 5c illustrent des dispositifs à ondes de surface selon l'invention comprenant un substrat porteur évidé ;
- la figure 6 illustre un mode de commande d'un transducteur unidirectionnel selon l'invention ;
- les figures 7a-7c illustrent un exemple de filtre utilisant un dispositif à ondes acoustiques de surface selon l'invention, avec électrodes en surface ou électrodes enterrées ;
- les figures 8a et 8b illustrent un autre exemple de filtre utilisant un dispositif à ondes de surface selon l'invention ;
- les figures 9a à 9c illustrent des exemples de dispositifs à ondes de surface encapsulés, selon l'invention ;
- la figure 10 illustre un autre exemple de dispositifs à onde de surface encapsulés selon l'invention.

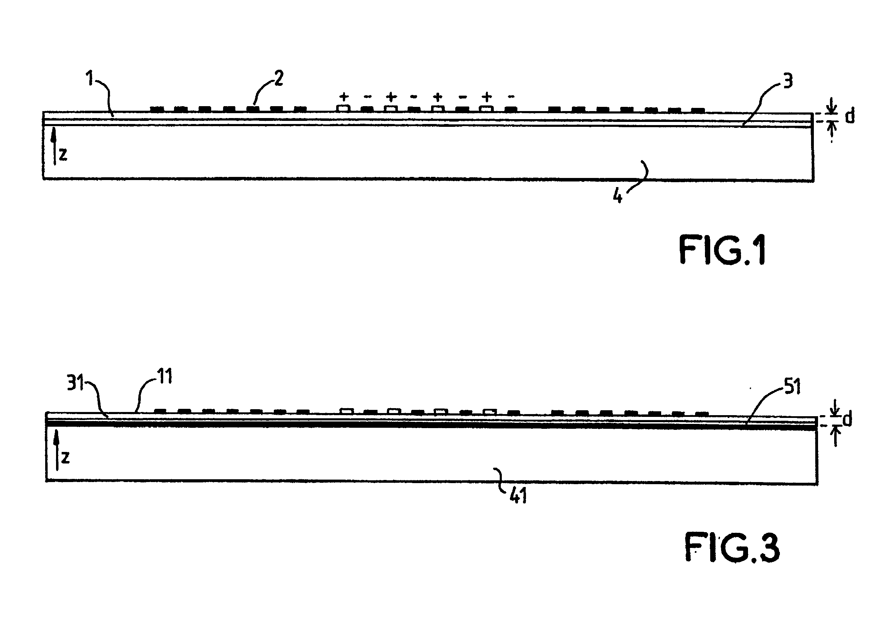

De manière générale, le dispositif à ondes acoustiques comprend au moins une couche de matériau piézo-électrique 1, sur ou dans laquelle sont distribuées les électrodes 2 pour assurer les fonctions de transduction et réflexion recherchées, une couche de colle moléculaire 3, et un substrat support 4, comme illustré en figure 1, qui représente plus précisément un exemple de transducteur inséré entre deux réseaux de réflecteurs.

L'épaisseur de la couche de matériau piézo-électrique est telle qu'elle conduit à des modes de propagation de l'énergie acoustique, guidés.

La couche de colle dite « moléculaire » est une couche de matériau capable d'établir des liaisons de type hydrophiliques avec les matériaux aux interfaces, typiquement il peut s'agir de silice, capable en atmosphère humide d'établir des liaisons de type O-H avec d'autres matériaux aux interfaces comprenant également des atomes d'oxygène.

Pratiquement, lorsque l'on utilise un substrat porteur de type silicium, on peut réaliser à la surface du substrat porteur un dépôt par pulvérisation ou « sputtering », de SiO₂ sur quelques dizaines de nm (centaines d'Angströms), il en est de même lorsque le substrat porteur est en arséniure de gallium GaAs. II devient alors possible d'établir des liaisons entre la couche de SiO₂ et des matériaux piézo-électriques comprenant de l'oxygène comme le quartz, LiTaO₃ ou LiNbO₃.

Avec la structure retenue pour l'invention, en réalisant des épaisseurs fines de matériau piézo-électrique réduites aux dimensions d'une longueur d'onde acoustique, c'est-à-dire d'environ 1 µm à 30 µm, la vitesse de ondes acoustiques de volume devenant plus grande dans le substrat porteur que dans la couche de matériau piézo-électrique, cette dernière peut présenter les caractéristiques d'un guide d'ondes acoustiques. Or, les structures à ondes acoustiques guidées offrent plusieurs avantages notables au regard des dispositifs à ondes acoustiques de surface non-guidées traditionnelles, soit:
- des pertes plus faibles;
- des coefficients de réflexion plus élevés;
- une résistance à la puissance plus élevée, en particulier si les ondes acoustiques sont polarisées dans un plan horizontal.

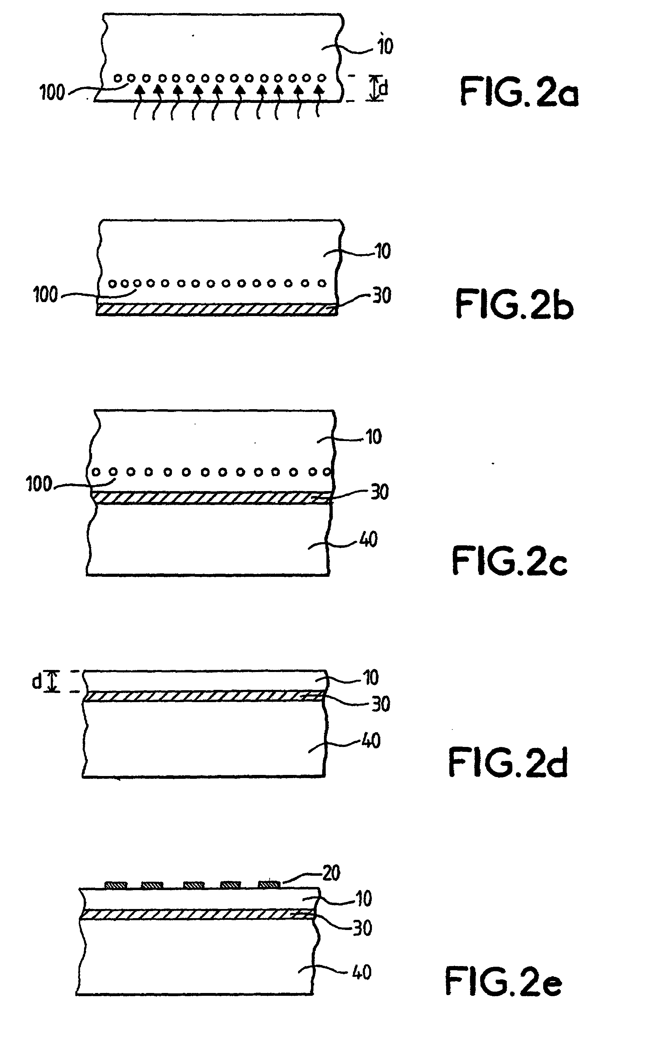

Le dispositif à ondes acoustiques de l'invention comprend une fine couche de matériau piézo-électrique, l'épaisseur faible peut être obtenue par gravure mécanique, chimique ou encore plasma à partir d'une couche plus épaisse, après assemblage par collage moléculaire sur le substrat support. Cependant pour les couches très minces, ces techniques restent onéreuses c'est pourquoi l'invention propose un procédé pour réaliser les couches très minces. Les principales étapes de ce procédé sont illustrées en figure 2.

La première étape du procédé consiste à implanter des ions, par exemple de type hydrogène dans un substrat piézo-électrique 10. La puissance du bombardement ionique règle la profondeur d, d'implantation de ions 100 (figure 2a).

Dans un second temps, on procède au dépôt d'une couche 30 colle moléculaire par exemple de type SiO₂, ce dépôt peut être effectué par pulvérisation, l'ensemble obtenu est illustré en figure 2b.

Une troisième étape illustrée en figure 2c, consiste à assembler un substrat porteur 40 avec l'ensemble colle 30 et substrat piézo-électrique 10. Cette opération peut être effectuée sous atmosphère contrôlée.

Une quatrième étape illustrée en figure 2d permet de définir la fine couche de matériau piézo-électrique. Cette étape est effectuée en chauffant rapidement l'ensemble élaboré à l'étape précédente. II se produit une opération de craquage au niveau des impuretés implantées qui permet de définir la couche piézo-électrique d'épaisseur d. Cette étape de craquage est avantageusement suivie d'une opération de polissage de la surface de matériau piézo-électrique, étape non représentée, avant la cinquième étape illustrée en figure 2e qui consiste à définir le dispositif à ondes de surface (DOS) par dépôts d'électrodes.

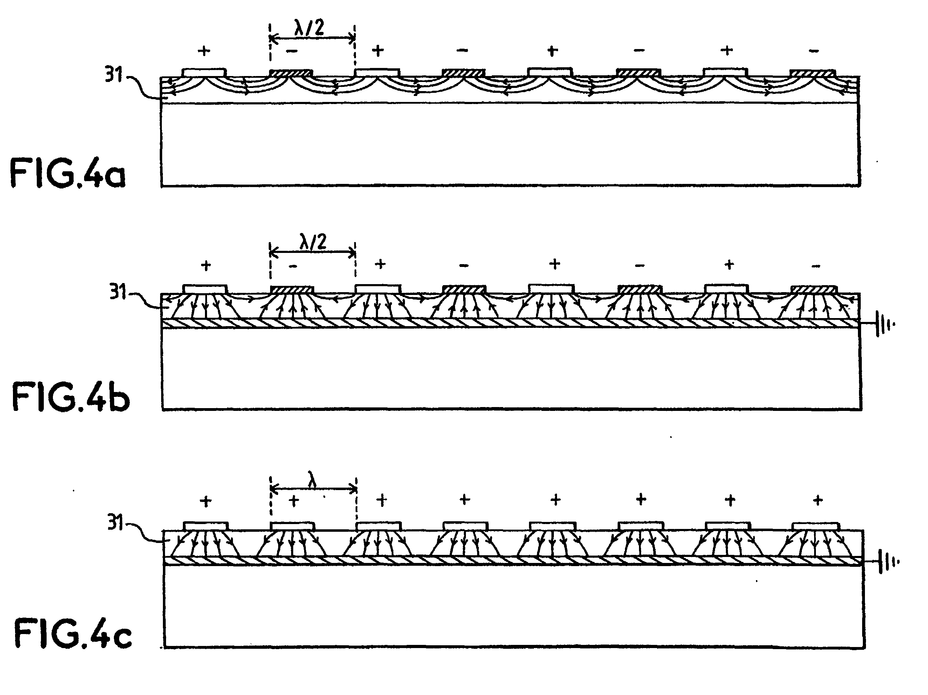

La structure de dispositif à ondes de surface de l'invention peut être perfectionnée dans le cas d'un substrat support de type silicium dans lequel il peut y avoir de substantielles pertes en raison de la faible résistivité du matériau. Dans ce type de configuration, il peut être en effet avantageux d'insérer une couche métallique entre le substrat porteur et la couche de colle moléculaire comme l'illustre la figure 3. Ainsi un substrat porteur 41 supporte une couche métallique 51, une couche de colle moléculaire 31 et une fine couche de matériau piézo-électrique 11 sur laquelle sont déposées les électrodes 21. La fine couche métallique 51 constitue un blindage conducteur entre la couche piézo-électrique et le substrat porteur de telle sorte que les lignes de champs électriques de la couche piézo-électrique 11 soient confinées. La fine couche métallique peut être déposée sur la surface du substrat piézo-électrique, sur le substrat porteur, ou sur les deux. Une couche de colle moléculaire peut alors être déposée à la surface de la couche métallique ou du substrat porteur ou du matériau piézo-électrique. L'insertion d'une couche conductrice présente plusieurs autres avantages que de faire écran aux champs électriques. Ces avantages sont notamment illustrés grâce aux figures 4a-4c. Plus précisément, la figure 4a montre schématiquement les lignes de champ dans la couche piézo-électrique sous un transducteur en l'absence de couche conductrice. La figure 4b quant à elle, montre schématiquement le même phénomène en présence d'une couche conductrice. II faut noter la pénétration plus profonde des lignes de champ dans l'ensemble de la couche, dans le deuxième cas de figure. II en résulte un accroissement du coefficient de couplage électroacoustique du transducteur.

Selon les cas, le transducteur peut comprendre des connexions non-équilibrées, c'est-à-dire, la première connexion est à un potentiel donné, la seconde connexion est toujours à un potentiel zéro (c'est-à-dire lié à la masse) ou bien des connexions équilibrées, c'est-à-dire deux connexions au même potentiel, mais avec une différence de phase de 180 degrés.

Toutefois, pour une performance optimale en cas d'alimentation équilibrée ou non équilibrée, la couche conductrice peut être mise à la masse. La figure 4c montre une autre réalisation dans laquelle la seconde phase du signal d'entrée est connectée à la face conductrice à l'interface des deux substrats. Cela présente l'avantage non négligeable de doubler les dimensions du schéma d'électrodes interdigitées d'un transducteur. La périodicité des électrodes requise dans cette configuration est λ, où λ est la longueur d'onde acoustique alors que dans les cas présentés auparavant, cette périodicité était de λ/2. La figure 4c propose ainsi une structure pouvant doubler la fréquence des opérations du dispositif.

Dans les cas ou le substrat porteur a une forte résistivité ; par exemple du verre ou du saphir, un blindage électrique entre le substrat piézo-électrique et le substrat porteur n'est pas nécessaire pour éviter les pertes conductrices dans ce dernier substrat. Donc des structures équivalentes à celles décrites en figures 4a à 4c peuvent être réalisées en enterrant les électrodes comme cela sera illustré ci-après. Les avantages de ces dernières implantations sont le couplage piézo-électrique plus fort parce que les électrodes sont enterrées et le blindage du filtre vis-à-vis des champs électriques extérieurs.

II est également possible d'obtenir des effets comparables en enterrant les électrodes d'un transducteur dans la couche piézo-électrique. Cette configuration permet de la même manière qu'une couche conductrice enterrée d'accroître la profondeur de pénétration des lignes de champ électrique à l'intérieur du matériau piézo-électrique. Dans une structure de dispositifs à ondes de surface de l'art antérieur, il est très difficile d'obtenir des performances constantes et reproductibles avec des électrodes enterrées car il est très difficile de graver le substrat piézo-électrique à la profondeur désirée de manière précise. En revanche dans le cas de la présente invention, cela ne présente aucune difficulté. En choisissant un procédé de gravure chimique sélectif il est possible de graver uniquement et intégralement un endroit précis de la couche fine de matériau piézo-électrique. Les rainures ainsi gravées dans le guide d'ondes peuvent alors être remplies de métal par l'une quelconque des techniques existantes telles que l'évaporation ou la pulvérisation. Un transducteur ainsi gravé aura un meilleur couplage.

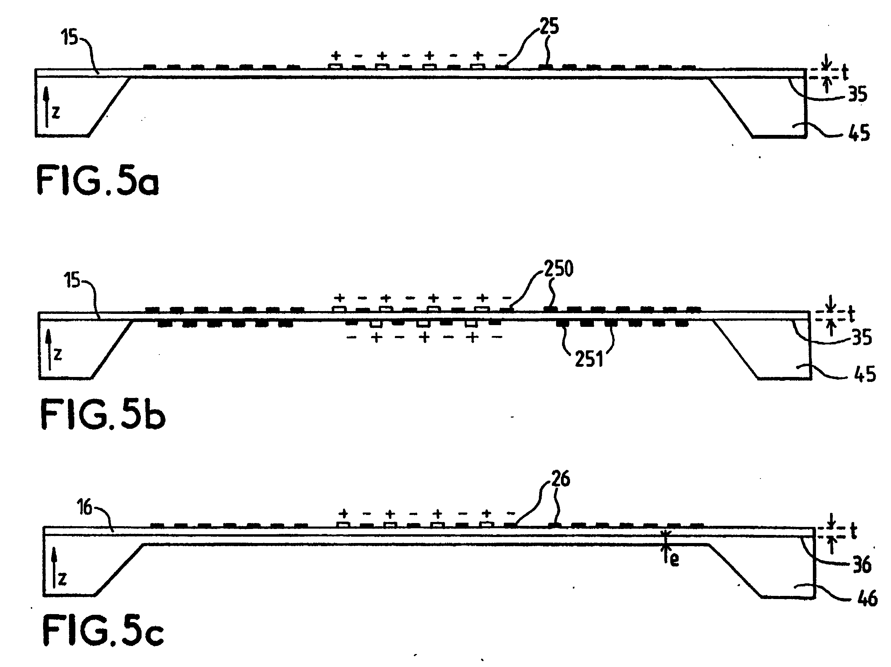

Selon l'invention, il est avantageux de réduire les pertes dans le matériau support en évidant ledit matériau porteur sous la surface active du dispositif à ondes acoustiques de surface. La figure 5a illustre un dispositif à ondes de surface dans lequel le substrat porteur 45 est complètement gravé en regard de la zone active du matériau piézo-électrique 15 comprenant les électrodes 25 et ce jusqu'à la couche de colle moléculaire 35. Selon une autre variante, la couche de colle moléculaire peut également être gravée. Dans le cas d'un substrat porteur silicium, on peut utiliser des techniques bien connues de gravure chimique ou de gravure plasma.

II peut être également très intéressant, dans le cadre de l'invention de réaliser un transducteur unidirectionnel à partir du matériau support complètement évidé décrit précédemment. La figure 5b illustre un tel transducteur. A partir de la couche mince piézo-électrique il est possible de réaliser sur les deux faces du substrat piézo-électrique des jeux d'électrodes. Un premier jeu 250 est réalisé sur l'une des faces, puis sert de masque dans la réalisation du second jeu 251, dans la mesure où le substrat piézo-électrique est transparent aux longueurs d'onde d'insolation utilisées dans les procédés de lithographie pour la réalisation des électrodes.

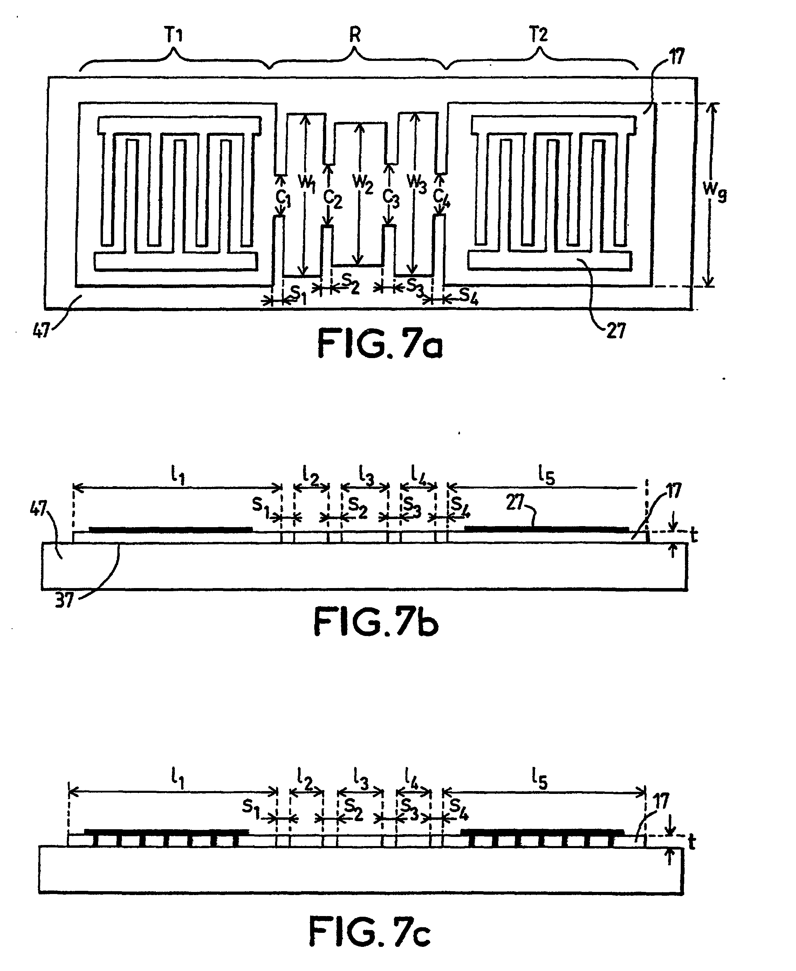

Pour réaliser une radiation d'énergie acoustique dans une seule direction, le transducteur est alimenté par deux entrées avec une différence de phase de 90 degrés. Une alimentation de telle sorte est facilement obtenue par une quadrature hybride illustrée en figure 6, connue de l'art antérieur. Dans ce cas les électrodes sur la surface supérieure sont alimentées avec la sortie 1 et les électrodes sur la surface inférieure sont alimentées avec la sortie 2. Un transducteur unidirectionnel réalisé de cette façon est large bande et très efficace.

II est à noter que l'évidage du substrat porteur peut être intéressant même lorsque la résistivité du matériau porteur est suffisante. Par exemple, en fonction du matériau piézo-électrique et du matériau porteur, le support pourra être évidé ne laissant qu'une épaisseur déterminée e de matériau sous le dispositif à ondes de surface, comme illustré en figure 5c. En effet, en regard des électrodes 26 disposées à la surface de la fine couche de matériau piézo-électrique 16, collée par une couche de colle 36 au substrat support 46, ce dernier est évidé jusqu'à une épaisseur e de matériau support. Avec une telle architecture, il devient possible de compenser les variations de température et ainsi réduire de manière importante la sensibilité du dispositif à la température.

Comme cela a été évoqué précédemment, le dispositif à ondes de surface (DOS) de l'invention, de part sa fine couche de matériau piézo-électrique présente des coefficients de réflexion supérieurs, voire voisin de 100 % si l'on grave des réseaux dans le guide de matériau piézo-électrique. En effet, dans de telles structures, l'énergie n'est pas perdue ou dispersée sous forme d'ondes de volume. De plus, comme l'énergie est confinée entièrement à l'intérieur du guide, on obtient de très hauts niveaux de réflexion et d'isolation dans les différentes sections du guide d'onde en le gravant, réduisant ainsi sa hauteur et/ou sa largeur. Dans ce cadre, la figure 7 illustre la réalisation d'un filtre à faibles pertes, très performant grâce notamment aux coefficients de réflexions élevés. II s'agit d'un filtre constitué de deux transducteurs T₁ et T₂ séparés par un réseau R, obtenu par différentes gravures du guide piézo-électrique. La figure 7a illustre une vue de dessus du DOS, et la figure 7b une vue en coupe. Le mince guide d'onde piézo-électrique 17 est gravé jusqu'à la colle de couche moléculaire 37 ou jusqu'au substrat porteur 47 par gravure chimique ou plasma par exemple. On définit alors un schéma d'électrodes 27, de manière à obtenir une série de cavités résonantes en lignes, dont chaque fréquence de résonance est fonction de la longueur de cavité Iₙ (dans l'exemple 1 ≤ n ≤ 5).

L'impédance de chacune des cavités peut être modifiée en changeant la largeur du guide d'ondes acoustique dans chaque section Wn.

Le couplage entre chacune des cavités est contrôlé par l'ouverture du guide Cn et la longueur des fentes Sn. Selon cette méthode, un filtre acoustique peut être élaboré exactement de la même manière qu'un filtre à ondes électromagnétiques guidées classique. La longueur de chaque cavité interne n'est que de l'ordre de λ/2. Un tel filtre peut par conséquent être plus petit que les filtres à ondes acoustiques de surface de l'art connu dont les réseaux de réflecteurs nécessitent des cavités internes de l'ordre de 100λ.

La figure 7c constitue une alternative de filtre dans laquelle les électrodes des transducteurs sont creusées dans le substrat piézo-électrique au lieu d'être dans le plan. Comme cela a été explicité précédemment, les transducteurs ont ainsi un meilleur couplage et permettent d'obtenir des filtres de dimensions plus faibles.

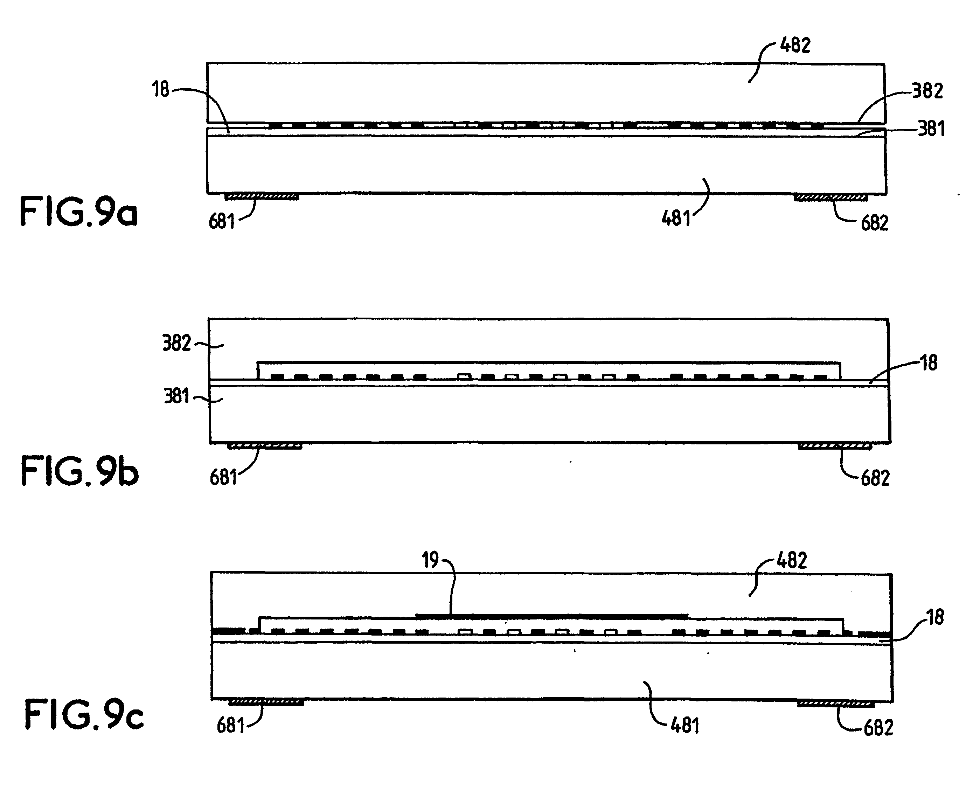

Les figures 8a et 8b constituent des alternatives des structures illustrées aux figures 7a et 7b, la différence entre ces structures réside dans le couplage qui n'est plus en ligne mais à côté.

L'invention concerne également des DOS encapsulés de manière intéressante en terme de coût et de taille.

En effet, le coût de l'encapsulation qui le plus souvent doit être hermétique, représente actuellement une part importante du prix de production du composant. Pour ce qui concerne la production en grande série, il est très important de réduire le plus possible ce prix. Dans ce contexte, il peut être très intéressant d'utiliser également une fine couche de colle moléculaire pour coller un couvercle d'encapsulation sur la fine couche de matériau piézo-électrique.

La figure 9a illustre un premier exemple de dispositif à ondes de surface dans lequel les électrodes sont intégrées dans une fine couche 18 de matériau piézo-électrique, ledit matériau piézo-électrique étant collé par l'intermédiaire d'une couche de colle moléculaire 381 sur un premier substrat porteur 481. Un second substrat porteur 482 est également collé par l'intermédiaire d'une couche de colle moléculaire 382, sur la couche de matériau piézo-électrique, de manière à assurer l'encapsulation. Un boîtier selon cette approche, est un boîtier plein (sans cavité), d'une grande robustesse. Des lors que la vitesse des ondes de volume dans le substrat porteur est plus grande que celle dans le guide, on peut obtenir de très faibles pertes de propagation. Des plots conducteurs 681 et 682 assurent de manière classique, au travers du substrat 481, les connexions électriques avec le composant à ondes acoustiques de surface.

La figure 9b illustre un dispositif à ondes de surface selon l'invention (ici représenté un transducteur entre deux réseaux réflecteurs), avec des électrodes en surface et non plus intégrées. Un substrat porteur localement évidé est collé en périphérie sur une couche de matériau piézo-électrique par l'intermédiaire d'une couche de colle moléculaire. Cette approche par rapport à la précédente a l'avantage de ne pas modifier les caractéristiques mesurées du dispositif à ondes acoustiques, avant le collage du substrat porteur supérieur. Dans la structure illustrée en figure 9c, l'absence de cavité entraîne en effet une différence de réponse du dispositif après collage du substrat porteur, ceci complique la vérification du test du dispositif pendant le processus de production. Par ailleurs, le substrat porteur, évidé servant de couvercle de boîtier d'encapsulation peut avantageusement comprendre des composants actifs 19, d'adaptation ou autre, intégrés au boîtier comme l'illustre la figure 9c. Si l'intérieur de la cavité est métallisé, cela permet de surcroît un blindage électrique particulièrement important dans les applications RF.

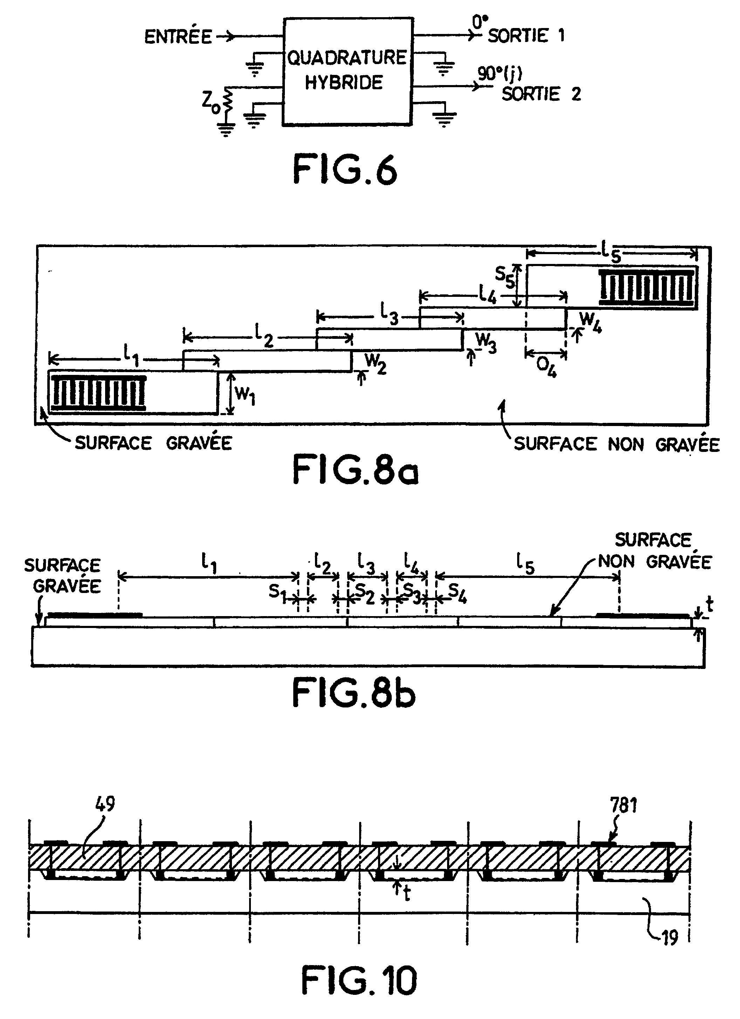

La figure 10 illustre une variante de dispositifs à ondes de surface encapsulés collectivement. Dans ce cas, on grave des cavités dans le substrat piézo-électrique 19. Puis on réalise la métallisation et l'étape de photolithographie, pour enfin coller le substrat piézo-électrique sur le substrat porteur céramique (par exemple) avec les vias, et les métallisations 781. La dernière étape consiste à séparer les composants de manière mécanique avec une scie.

## Revendications

1. Dispositif à ondes acoustiques de surface comprenant des moyens (25) pour créer des ondes acoustiques de surface et une couche mince de matériau piézo-électrique (18) dans laquelle sont guidées les ondes acoustiques et
- un substrat porteur (45) et une couche de colle moléculaire (35,381) permettant de coller la couche mince de matériau piézo-électrique sur le substrat porteur; **caractérisé en ce que**
- les moyens pour créer les ondes acoustiques de surface sont situés sur une partie centrale du matériau piézo-électrique ; et
- le substrat porteur est évidé en regard de ladite partie centrale.

2. Dispositif à ondes acoustiques de surface selon la revendication 1, **caractérisé en ce que** le matériau porteur peut être de type verre, saphir, silicium, arséniure de gallium.

3. Dispositif à ondes acoustiques de surface selon l'une des revendications 1 ou 2, **caractérisé en ce que** la colle moléculaire est de la silice.

4. Dispositif à ondes acoustiques de surface selon la revendication 3, **caractérisé en ce que** l'épaisseur de la couche de colle moléculaire est de l'ordre de quelques dizaines de nm (centaines d'Angströms).

5. Dispositif à ondes acoustiques de surface selon l'une des revendications 1 à 4, **caractérisé en ce qu'**il comprend une couche métallique (51) entre la couche de colle moléculaire et la couche de matériau piézo-électrique.

6. Dispositif à ondes acoustiques de surface selon l'une des revendications 1 à 5, **caractérisé en ce que** le matériau piézo-électrique est de type quartz, niobate de lithium, tantalate de lithium.

7. Dispositif à ondes acoustiques de surface selon l'une des revendications 1 à 6, **caractérisé en ce que** l'épaisseur de la couche de matériau piézo-électrique est de l'ordre d'une longueur d'onde acoustique comprise entre environ 1 µm et 30 µm.

8. Dispositif à ondes acoustiques de surface selon l'une des revendications 1 à 7, **caractérisé en ce qu'**il comprend des électrodes intégrées dans la couche mince de matériau piézo-électrique.

9. Dispositif à ondes acoustiques de surface selon l'une des revendications 1 à 8, **caractérisé en ce que** le substrat porteur est évidé complètement jusqu'à la couche mince de matériau piézo-électrique et qu'il comprend une première série d'électrodes sur une première face de la couche de matériau piézo-électrique et une seconde série d'électrodes sur la face opposée à la première face de la couche de matériau piézo-électrique.

10. Dispositif à ondes acoustiques de surface selon l'une des revendications 1 à 9, **caractérisé en ce qu'**il comprend deux transducteurs séparés par un réseau de réflecteurs gravés dans la couche mince de matériau piézo-électrique, de manière à définir une série de cavités résonantes en lignes de longueur In.

11. Module comprenant un dispositif à ondes acoustiques de surface selon l'une des revendications 1 à 10, et un boîtier d'encapsulation dans lequel est intégré le dispositif, **caractérisé en ce que** le boîtier d'encapsulation comprend un second substrat porteur (482) collé par une seconde couche moléculaire (382) sur une partie au moins de la couche de matériau piézo-électrique (18).

12. Module selon la revendication 11, **caractérisé en ce que** le second substrat porteur est collé par la seconde couche moléculaire sur l'ensemble de la couche de matériau piézo-électrique.

13. Module selon la revendication 11, **caractérisé en ce que** le substrat porteur est évidé en son centre et collé au niveau de sa périphérie sur la périphérie de la couche de matériau piézo-électrique.

14. Procédé de fabrication d'un dispositif selon l'une des revendications 1 à 13, **caractérisé en ce qu'**il comprend les étapes suivantes :
- le dépôt d'une couche de colle moléculaire (35; 381) sur une première face d'un substrat de matériau piézo-électrique (18).
- l'assemblage d'un substrat porteur (45) et de l'ensemble couche de colle moléculaire/substrat de matériau piézo-électrique sous atmosphère humide de manière à réaliser une opération de collage hydrophilique, le substrat porteur étant évidé dans une partie centrale du matériau piézo-électrique sur laquelle sont situées des moyens (25) pour créer des ondes acoustiques de surface,
- la réduction de l'épaisseur du substrat piézo-électrique par un procédé de type mécanique, chimique, ionique, de manière à définir la couche mince de matériau piézo-électrique.

15. Procédé de fabrication d'un dispositif selon la revendication 14, **caractérisé en ce qu'**il comprend en outre les étapes suivantes :
- l'implantation d'ions dans le substrat de matériau piézo-électrique à une profondeur d par rapport à une première face d'un substrat de matériau piézo-électrique ;
- le chauffage rapide de l'assemblage couche de colle moléculaire/substrat de matériau piézo-électrique de manière à craquer le substrat de matériau piézo-électrique au niveau de la profondeur d'implantation ionique et définir la couche mince de matériau piézo-électrique,
- le polissage de la couche mince de matériau piézo-électrique.

## Patentansprüche

1. Akustische Oberflächenwellenvorrichtung, die Mittel (25) zur Erzeugung akustischer Oberflächenwellen und eine dünne Schicht aus piezoelektrischem Material (18), in der die akustischen Wellen geführt werden, und ein Trägersubstrat (45) und eine Schicht aus molekularem Klebstoff (35; 381) aufweist, die es ermöglicht, die dünne Schicht aus piezoelektrischem Material auf das Trägersubstrat zu kleben, **dadurch gekennzeichnet, dass**
- die Mittel zur Erzeugung der akustischen Oberflächenwellen sich in einem zentralen Bereich des piezoelektrischen Materials befinden, und
- das Trägersubstrat gegenüber dem zentralen Bereich ausgehöhlt ist.

2. Akustische Oberflächenwellenvorrichtung nach Anspruch 1, **dadurch gekennzeichnet, dass** das Trägermaterial von der Art Glas, Saphir, Silicium, Galliumarsenid sein kann.

3. Akustische Oberflächenwellenvorrichtung nach einem der Ansprüche 1 und 2, **dadurch gekennzeichnet, dass** der molekulare Klebstoff Siliciumdioxid ist.

4. Akustische Oberflächenwellenvorrichtung nach Anspruch 3, **dadurch gekennzeichnet, dass** die Dicke der Schicht aus molekularem Klebstoff in der Größenordnung von einigen Zehn nm (einigen Hundert Angström) liegt.

5. Akustische Oberflächenwellenvorrichtung nach einem der Ansprüche 1 bis 4, **dadurch gekennzeichnet, dass** sie eine Metallschicht (51) zwischen der Schicht aus molekularem Klebstoff und der Schicht aus piezoelektrischem Material aufweist.

6. Akustische Oberflächenwellenvorrichtung nach einem der Ansprüche 1 bis 5, **dadurch gekennzeichnet, dass** das piezoelektrische Material von der Art Quarz, Lithiumniobat, Lithiumtantalat ist.

7. Akustische Oberflächenwellenvorrichtung nach einem der Ansprüche 1 bis 6, **dadurch gekennzeichnet, dass** die Dicke der Schicht aus piezoelektrischem Material in der Größenordnung einer akustischen Wellenlänge liegt, die zwischen etwa 1 µm und 30 µm liegt.

8. Akustische Oberflächenwellenvorrichtung nach einem der Ansprüche 1 bis 7, **dadurch gekennzeichnet, dass** sie Elektroden aufweist, die in die dünne Schicht aus piezoelektrischem Material integriert sind.

9. Akustische Oberflächenwellenvorrichtung nach einem der Ansprüche 1 bis 8, **dadurch gekennzeichnet, dass** das Trägersubstrat vollständig bis zur dünnen Schicht aus piezoelektrischem Material ausgehöhlt ist, und dass es eine erste Reihe von Elektroden auf einer ersten Fläche der Schicht aus piezoelektrischem Material und eine zweite Reihe von Elektroden auf der der ersten Fläche aus piezoelektrischem Material gegenüberliegenden Fläche aufweist.

10. Akustische Oberflächenwellenvorrichtung nach einem der Ansprüche 1 bis 9, **dadurch gekennzeichnet, dass** sie zwei Wandler aufweist, die durch ein Netz von Reflektoren getrennt sind, die in die dünne Schicht aus piezoelektrischem Material so eingraviert sind, dass sie eine Reihe von Resonanzhohlräumen in Reihen einer Länge In definieren.

11. Modul, der eine akustische Oberflächenwellenvorrichtung nach einem der Ansprüche 1 bis 10 und ein Verkapselungsgehäuse aufweist, in das die Vorrichtung integriert ist, **dadurch gekennzeichnet, dass** das Verkapselungsgehäuse ein zweites Trägersubstrat (482) aufweist, das durch eine zweite molekulare Schicht (382) auf zumindest einen Teil der Schicht aus piezoelektrischem Material (18) geklebt ist.

12. Modul nach Anspruch 11, **dadurch gekennzeichnet, dass** das zweite Trägersubstrat durch die zweite molekulare Schicht auf die Gesamtheit der Schicht aus piezoelektrischem Material geklebt ist.

13. Modul nach Anspruch 11, **dadurch gekennzeichnet, dass** das Trägersubstrat in seiner Mitte ausgehöhlt und in Höhe seines Umfangs auf den Umfang der Schicht aus piezoelektrischem Material geklebt ist.

14. Verfahren zur Herstellung einer Vorrichtung nach einem der Ansprüche 1 bis 13, **dadurch gekennzeichnet, dass** es die folgenden Schritte aufweist:
- Aufbringen einer Schicht aus molekularem Klebstoff (35; 381) auf eine erste Fläche eines Substrats aus piezoelektrischem Material (18),
- Zusammensetzen eines Trägersubstrats (45) und der Einheit aus der Schicht aus molekularem Klebstoff und dem Substrat aus piezoelektrischem Material unter Feuchtatmosphäre, um einen hydrophilen Klebvorgang durchzuführen, wobei das Trägersubstrat in einem zentralen Bereich des piezoelektrischen Materials ausgehöhlt ist, auf dem Mittel (25) zur Erzeugung akustischer Oberflächenwellen angeordnet sind,
- Reduzieren der Dicke des piezoelektrischen Substrats durch ein Verfahren mechanischer, chemischer, ionischer Art, um die dünne Schicht aus piezoelektrischem Material zu definieren.

15. Verfahren zur Herstellung einer Vorrichtung nach Anspruch 14, **dadurch gekennzeichnet, dass** es weiter die folgenden Schritte aufweist:
- Implantieren von Ionen in das Substrat aus piezoelektrischem Material in einer Tiefe d bezüglich einer ersten Fläche eines Substrats aus piezoelektrischem Material;
- schnelles Erwärmen der Zusammensetzung aus der Schicht aus molekularem Klebstoff und dem Substrat aus piezoelektrischem Material, um das Substrat aus piezoelektrischem Material in Höhe der Tiefe der Ionenimplantation aufzubrechen und die dünne Schicht aus piezoelektrischem Material zu definieren,
- Polieren der dünnen Schicht aus piezoelektrischem Material.

## Claims

1. Surface acoustic wave device comprising means (25) for creating surface acoustic waves, a thin layer of piezoelectric material (19), in which the acoustic waves are guided, a carrier substrate (45) and a layer of molecular bonding agent (35; 381) for bonding the thin layer of piezoelectric material to the carrier substrate, **characterized in that** the means for creating the surface acoustic waves are located on a central portion of the piezoelectric material and the carrier substrate is cut out facing the said central portion.

2. Surface acoustic wave device according to Claim 1, **characterized in that** the carrier material may be of the glass, sapphire, silicon or gallium arsenide type.

3. Surface acoustic wave device according to either of Claim 1 and 2, **characterized in that** the molecular bonding agent is silica.

4. Surface acoustic wave device according to Claim 3, **characterized in that** the thickness of the layer of molecular bonding agent is of the order of a few tens of nm (hundreds of angstroms).

5. Surface acoustic wave device according to one of Claims 1 to 4, **characterized in that** it includes a metal layer (51) between the layer of molecular bonding agent and the layer of piezoelectric material.

6. Surface acoustic wave device according to one of Claims 1 to 5, **characterized in that** the piezoelectric material is of the quartz, lithium niobate or lithium tantalate type.

7. Surface acoustic wave device according to one of Claims 1 to 6, **characterized in that** the thickness of the layer of piezoelectric material is of the order of an acoustic wavelength, lying between about 1 µm and 30µm.

8. Surface acoustic wave device according to one of Claims 1 to 7, **characterized in that** it includes electrodes integrated into the thin layer of piezoelectric material.

9. Surface acoustic wave device according to one of Claims 1 to 8, **characterized in that** the carrier substrate is cut away completely right down to the thin layer of piezoelectric material and it includes a first series of electrodes on a first face of the layer of piezoelectric material and a second series of electrodes on the opposite face from the first face of the layer of piezoelectric material.

10. Surface acoustic wave device according to one of Claims 1 to 9, **characterized in that** it includes two transducers that are separated by an array of reflectors etched in the thin layer of piezoelectric material, so as to define a series of resonant cavities in rows of length lₙ.

11. Module comprising a surface acoustic wave device according to one of Claims 1 to 10 and an encapsulation package in which the device is integrated, **characterized in that** the encapsulation package comprises a second carrier substrate (482) molecularly bonded by a second molecular layer (382) to at least one portion of the layer of piezoelectric material (18).

12. Module according to Claim 11, **characterized in that** the second carrier substrate is molecularly bonded by the second molecular layer to the entire layer of piezoelectric material.

13. Module according to Claim 11, **characterized in that** the carrier substrate is cut out at its centre and molecularly bonded around its periphery to the periphery of the layer of piezoelectric material.

14. Process for fabricating a device according to one of Claims 1 to 13, **characterized in that** it comprises the following steps:
- the deposition of a layer of molecular bonding agent (35, 381) to a first face of a substrate of piezoelectric material (18);
- the joining of a carrier substrate (45) to the molecular bonding layer/piezoelectric substrate assembly in a wet atmosphere so as to carry out a hydrophilic molecular bonding operation, the carrier substrate being cut out in a central portion of the piezoelectric material, in which portion the means (25) for creating surface acoustic waves are located; and
- reduction of the thickness of the piezoelectric substrate by a process of the mechanical, chemical or ion milling type so as to define the thin layer of piezoelectric material.

15. Process for fabricating a device according to Claim 14, **characterized in that** it furthermore includes the following steps:
- ion implantation in the piezoelectric substrate at a depth d measured from a first face of a piezoelectric substrate;
- rapid heating of the molecular bonding layer/piezoelectric substrate assembly so as to crack the piezoelectric substrate at the ion implantation depth and to define the thin layer of piezoelectric material; and
- polishing of the thin layer of piezoelectric material.
